(19) **Europäisches Patentamt European Patent Office Office européen des brevets**

(11) **EP 3 702 430 A1**

(12) **EUROPEAN PATENT APPLICATION**
published in accordance with Art. 153(4) EPC

(43) Date of publication:
**02.09.2020 Bulletin 2020/36**

(51) Int Cl.:
*C09K 3/10* (2006.01)  *B32B 27/32* (2006.01)
*C08L 23/00* (2006.01)  *C08L 23/26* (2006.01)
*H01L 51/44* (2006.01)  *H01L 51/50* (2006.01)
*H05B 33/04* (2006.01)  *H05B 33/10* (2006.01)

(21) Application number: **18870064.5**

(22) Date of filing: **01.08.2018**

(86) International application number:
**PCT/JP2018/028883**

(87) International publication number:
**WO 2019/082468 (02.05.2019 Gazette 2019/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.10.2017  JP 2017208597**

(71) Applicant: **Moresco Corporation Kobe-shi, Hyogo 650-0047 (JP)**

(72) Inventors:
• **ICHIKAWA, Hisashi**
  **Kobe-shi**
  **Hyogo 650-0047 (JP)**
• **TANAKA, Naoya**
  **Kobe-shi**
  **Hyogo 650-0047 (JP)**
• **YANO, Junichi**
  **Kobe-shi**
  **Hyogo 650-0047 (JP)**

(74) Representative: **IP Trust**
  **2, rue de Clichy**
  **75009 Paris (FR)**

(54) **SEALING MATERIAL FOR FLEXIBLE ORGANIC DEVICE, AND USE THEREOF**

(57)  An object of an aspect of the present invention is to provide a sealing material which is excellent in optical characteristics, flexibility, water vapor barrier property, and adhesion strength with respect to barrier films. An aspect of the present invention achieves the above object by providing a sealing material which (a) contains a specific modified polyolefin resin or both of the specific modified polyolefin resin and a second polyolefin resin, and (b) satisfies (1) a specific degree of crystallinity and (2) a specific storage modulus.

EP 3 702 430 A1

## Description

Technical Field

The present invention relates to a sealing material for a flexible organic device, and a barrier film and a flexible organic device each of which includes the sealing material.

Background Art

Solar cells are expected to be a new energy source since solar cells utilize sunlight energy, which is clean and can be inexhaustibly supplied. Such solar cells are currently under development.

Solar cells are broadly classified into organic solar cells and inorganic solar cells. Inorganic solar cells, using silicon and/or the like, are so far developed and mass-produced earlier than organic solar cells. Accordingly, mainly, installation of inorganic solar cells is in progress. On the other hand, marketing of organic solar cells such as organic thin film solar cells has been just started. Organic solar cells are expected to be applied in broader fields different from those in which inorganic solar cells are applied.

A so-called "flexible organic device", which employs an organic device such as an organic thin film solar cell, is sealed by (i) providing two films (barrier films), which have a gas barrier property, on both sides of the "flexible organic device", respectively, and (ii) bonding the two films together. This is because the "flexible organic device" easily deteriorates due to, for example, gas (such as water vapor) in the air. These two barrier films are bonded together by an adhesive (sealing material). There are various aspects of the adhesive. According to one of the aspects, the adhesive is an adhesive which forms a thermoplastic sealant film on a surface of each of the barrier films. In a case where such a thermoplastic sealing material is used, the flexible organic device is sealed in a thermal lamination step of subjecting the two barrier films sandwiching an element, to thermocompression bonding for a short period of time. Accordingly, the sealing material which forms a thermoplastic sealant film allows for a simple process, which achieves excellent productivity and causes less damage to the element.

The flexible organic device is required to have characteristics such as being flexible, light in weight, and excellent in design. Accordingly, the sealing material used for the flexible organic device is desired to also have various characteristics (such as a high adhesion strength with respect to, for example, barrier films, a good design, flexibility, a gas barrier property, and a low amount of outgas) for achieving the above characteristics of the flexible organic device.

Some examples of currently known sealing materials for flexible organic devices encompass a sealing material containing an ethylene-vinyl acetate copolymer (EVA) as a main component (Patent Literature 1), a sealing material containing a cyclic aliphatic saturated hydrocarbon and an organic acid or an anhydride thereof (Patent Literature 2), and a sealing material containing a polyolefin and a tackifier (petroleum resin) (Patent Literature 3).

Citation List

[Patent Literature]

[Patent Literature 1]
International Publication No. WO 2012/073675 (Publication Date: June 7, 2012)
[Patent Literature 2]
Japanese Patent Application Publication *Tokukai* No. 2014-146582 (Publication Date: August 14, 2014)
[Patent Literature 3]
Japanese Patent Application Publication *Tokukai* No. 2017-027941 (Publication Date: February 2, 2017)

Summary of Invention

Technical Problem

However, the sealing material containing an ethylene-vinyl acetate copolymer (EVA) as a main component has a problem in that an organic device deterioration-preventing effect is low because of a low barrier property with respect to water vapor. Meanwhile, the sealing material containing a cyclic aliphatic saturated hydrocarbon and an organic acid or an anhydride thereof has a problem in that an adhesion strength with respect to the barrier films is insufficient. Further, the sealing material which contains a polyolefin and a tackifier (petroleum resin) so as to achieve a higher adhesion strength with respect to the barrier films has a problem in that gas (outgas) derived from the tackifier is easily produced and the outgas causes the flexible organic device to deteriorate.

In view of the above problems, an object of an aspect of the present invention is to provide a sealing material having excellent characteristics which solve the above problems, and a barrier film and a flexible organic device each of which includes the sealing material.

Solution to Problem

As a result of diligent studies for achieving the above object, the inventors of the present application have found that with use of a specific modified polyolefin resin in which a side chain(s) such as an acid anhydride(s) is/are given, it is possible to obtain a sealing material which is excellent in optical characteristics (such as haze and transparency), flexibility, and water vapor barrier property and which is also excellent in adhesion strength with respect to a barrier film even in a case where no tackifier is used. Then, the inventors have accomplished an embodiment of the present invention.

In other words, an embodiment of the present invention is a sealing material for a flexible organic device, the sealing material including:

a modified polyolefin resin,
the modified polyolefin resin being a polyolefin resin modified by at least one selected from the group consisting of an acid anhydride and a substitution product thereof, acrylic acid ester, methacrylic acid ester, vinyl ester, and a styrene derivative,
the sealing material satisfying the following (1) and (2):

(1) a degree of crystallinity in evaluation of degree of crystallinity (XRD) is in a range of 10% to 40%; and
(2) a storage modulus at 10°C to 50°C is in a range of 1 MPa to 100 MPa, the storage modulus being measured by a rotational rheometer.

Advantageous Effects of Invention

An aspect of the present invention has excellent effects with regard to, for example, optical characteristics (such as haze and transparency), flexibility, a water vapor barrier property, and adhesion strength with respect to a barrier film. Further, according to an embodiment of the present invention, the adhesion strength with respect to the barrier film is excellent even in a case where any tackifier is not particularly used. Therefore, it is possible to solve the problem of deterioration of a flexible organic device due to outgas generation.

Brief Description of Drawings

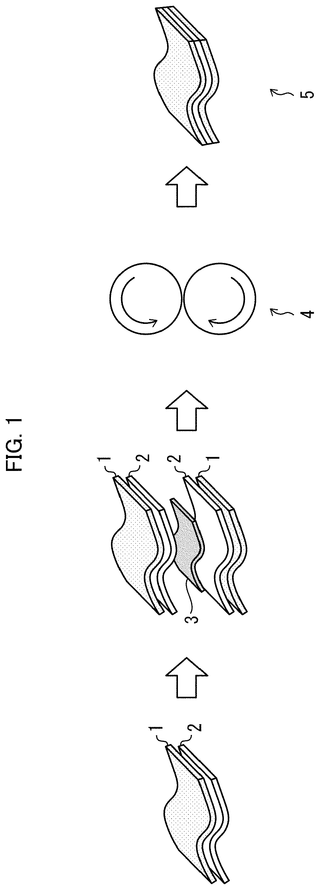

Fig. 1 is a view schematically illustrating steps for preparation of a flexible organic device by sealing an organic element between barrier films.

Description of Embodiments

The following will discuss in detail an embodiment of the present invention. Any numerical range expressed as "A to B" herein means "not less than A (A and more than A) and not more than B (B and less than B)" unless otherwise stated.

[1. Sealing material]

An embodiment of the present invention provides a sealing material for a flexible organic device. The sealing material contains a specific modified polyolefin resin. The sealing material satisfies the following characteristics (1) and (2): (1) a degree of crystallinity in evaluation of degree of crystallinity (XRD) is in a range of 10% to 40%; and (2) a storage modulus at 10°C to 50°C is in a range of 1 MPa to 100 MPa, the storage modulus being measured by a rotational rheometer. The sealing material in accordance with an embodiment of the present invention contains a polyolefin modified by at least one selected from the group consisting of an acid anhydride and a substitution product thereof, acrylic acid ester, methacrylic acid ester, vinyl ester, and a styrene derivative. The sealing material in accordance with an embodiment of the present invention is hereinafter referred to as a "sealing material of the present invention" as appropriate.

Since the sealing material of the present invention is configured as above, the sealing material of the present invention is excellent in total luminous transmittance, haze, flexibility, and water vapor barrier property, and also excellent in adhesion strength with respect to a barrier film even in a case where any tackifier is not used. These are advantageous effects of the sealing material of the present invention. Further, in the case of the sealing material of the present invention, it is possible to suppress outgas generation since particularly, addition of any tackifier is not necessary as described above. This advantageously makes it possible to prevent deterioration of the flexible organic device.

The term "modified polyolefin resin" herein means a polyolefin resin having a side chain(s) modified by a desired substance(s). Examples of the modified polyolefin resin encompass an acid-modified polyolefin resin, an alkyl-modified polyolefin resin, and an aromatic modified polyolefin resin.

The modified polyolefin resin in accordance with an embodiment of the present invention is a polyolefin resin modified by at least one selected from the group consisting of an acid anhydride and a substitution product thereof, acrylic acid ester, methacrylic acid ester, vinyl ester, and a styrene derivative.

The polyolefin resin to be modified is not particularly limited, provided that the polyolefin resin is usable in the technical field to which the present invention pertains. Examples of the polyolefin resin to be modified in an embodiment of the present invention encompass an ethylene polymer, a propylene polymer, a butene polymer, an ethylene-propylene copolymer, an ethylene-butene copolymer, and an ethylene-propylene-butene copolymer. The polyolefin resin to be modified in an embodiment of the present invention is preferably a propylene polymer, or an ethylene-propylene copolymer.

The above has described substances for modifying the polyolefin resin in an embodiment of the present invention. In an embodiment of the present invention, examples of the acid anhydride encompass maleic anhydride, phthalic anhydride, succinic anhydride, and glutaric anhydride. In an embodiment of the present invention, examples of the substitution product of the acid anhydride encompass citraconic anhydride, methylphthalic anhydride, and chlormaleic anhydride. In an embodiment of the present invention, examples of the acrylic acid ester encompass ethyl acrylate, butyl acrylate, and 2-ethylhexyl acrylate. In an embodiment of the present invention, examples of the methacrylic acid ester encompass butyl methacrylate, ethyl methacrylate, and t-butyl methacrylate. In an embodiment of the present invention, examples of the vinyl ester encompass vinyl acetate, vinyl propionate, and vinyl benzoate. In an embodiment of the present invention, examples of the styrene derivative encompass vinylbenzoic acid, p-methoxystyrene, and α-methylstyrene.

In an embodiment of the present invention, only one of the substances for modifying the polyolefin resin can be used alone or two or more of the substances can be used in combination. In a case where two or more of the substances for modifying the polyolefin resin are used in combination, an arrangement (combination) of the substances is not particularly limited. It is possible to use, for example, a combination of an acid anhydride and methacrylic acid ester, and preferably a combination of maleic anhydride and butyl methacrylate.

In an embodiment of the present invention, the content of the substance(s) for modifying the polyolefin resin in the modified polyolefin resin can be, for example, 0.01% by weight to 30% by weight, preferably 0.01% by weight to 10% by weight, and more preferably 0.1% by weight to 10% by weight, with respect to the polyolefin resin to be modified. If the content of the substance(s) for modifying the polyolefin resin in the modified polyolefin resin is in the above range, it is advantageously possible not only to achieve a suppressed deterioration in water vapor barrier property but also to ensure a required adhesion strength.

The sealing material of the present invention can contain, as the modified polyolefin resin, one or two or more kinds of modified polyolefin resins. In a case where two or more kinds of modified polyolefin resins are contained, an arrangement (combination) of the two or more kinds of modified polyolefin resins is not particularly limited. It is possible to use, for example, a combination of an acid-modified polypropylene and an acid-modified ethylene-polypropylene copolymer, a combination of an acid-modified polypropylene and an acid-modified polybutene, or a combination of an acid-modified polyethylene and an acid-modified ethylene-polypropylene copolymer.

In an embodiment of the present invention, the content of the modified polyolefin resin in the sealing material of the present invention can be, for example, 0.01% by weight to 100% by weight, preferably 0.1% by weight to 90% by weight, and more preferably 1% by weight to 80% by weight in a case where an involatile component content in the sealing material is 100% by weight. If the content of the modified polyolefin resin in the sealing material is in the above range, it is possible to advantageously have an excellent adhesion strength with respect to a barrier film.

The sealing material in accordance with an embodiment of the present invention may contain, together with the modified polyolefin resin described above, a polyolefin resin which is of the same kind as the modified polyolefin resin and which has not been modified. Such an aspect is also encompassed by an embodiment of the present invention.

In an embodiment of the present invention, a degree of crystallinity of the sealing material of the present invention can be, for example, 10% to 40%, and preferably 10% to 25%. The degree of crystallinity is obtained as a result of evaluation of degree of crystallinity by X-ray diffractometry (XRD) of the sealing material of the present invention. In a case where the lower limit of the degree of crystallinity is less than the above range, there arises a problem of an insufficient gas barrier property. On the other hand, in a case where the upper limit of the degree of crystallinity is more than the above range, there arises a problem of an increased haze.

In an embodiment of the present invention, a storage modulus of the sealing material of the present invention at 10°C to 50°C can be, for example, 1 MPa to 100 MPa, preferably 1 MPa to 50 MPa, and more preferably 1 MPa to 30 MPa. The storage modulus in the embodiment of the present invention is measured by a rotational rheometer. In a case where the lower limit of the storage modulus is less than the above range, there arises a problem of deterioration in creep resistance. On the other hand, in a case where the upper limit of the storage modulus is more than the above range, there arises a problem of deterioration in flexibility and/or adhesion strength.

Note that the evaluation of degree of crystallinity by the XRD and the storage modulus can be measured by, for example, respective methods described in Examples later.

In an embodiment of the present invention, the weight average molecular weight of the modified polyolefin resin in the sealing material of the present invention can be, for example, 1000 to 400000, preferably 5000 to 200000, and more preferably 10000 to 100000. The weight average molecular weight is obtained by gel permeation chromatography (GPC) measurement of the modified polyolefin resin. In a case where the lower limit of the weight average molecular weight of the modified polyolefin resin is less than the above range, there arises a problem of outgas generation due to a low molecular weight. In a case where the upper limit of the weight average molecular weight of the modified polyolefin resin is more than the above range, there arises a problem of difficulty in application of the sealing material to a base material due to an increased melt viscosity of the sealing material or an increased solution viscosity of the sealing material (in a case where the sealing material is prepared in the form of liquid).

The GPC measurement of the modified polyolefin resin can be carried out by, for example, a method described in Examples later.

The present invention provides, in an embodiment, a sealing material which further contains a second polyolefin resin different from the modified polyolefin resin (hereinafter, simply referred to as "second polyolefin resin"), in addition to the modified polyolefin resin.

The sealing material of the present invention brings about an excellent gas barrier property-obtaining effect, by further containing the second polyolefin resin.

Examples of the second polyolefin resin in accordance with an embodiment of the present invention encompass an ethylene-propylene copolymer, an ethylene-butene copolymer, a propylene-butene copolymer, an ethylene-propylene-butene copolymer, and a butene polymer. From the viewpoint of the gas barrier property, the second polyolefin resin is preferably a butene polymer.

The term "butene polymer" herein means a polymer obtained by polymerization with a monomer such as 1-butene, 2-butene, or isobutene. Examples of such a polymer encompass polybutene, polyisobutylene, etc. From the viewpoint of the gas barrier property, the butene polymer is preferably polyisobutylene.

In an embodiment of the present invention, the butene polymer can be crystalline or amorphous.

The sealing material of the present invention can contain, as the second polyolefin resin, only one or two or more kinds of second polyolefin resins. In a case where the sealing member contains two or more kinds of second polyolefin resins, an arrangement (combination) of the two or more kinds of the second polyolefin resins is not particularly limited. It is possible to use, for example, a combination of an ethylene-propylene copolymer and an ethylene-propylene-butene copolymer, a combination of an ethylene-propylene copolymer and a butene polymer, a combination of an ethylene-propylene-butene copolymer and a butene polymer, or a combination of an ethylene-propylene copolymer, an ethylene-propylene-butene copolymer and a butene polymer.

In an embodiment of the present invention, the weight average molecular weight of the second polyolefin resin in the sealing material of the present invention can be, for example, 2000 to 100000, preferably 5000 to 70000, and more preferably 5000 to 50000, in a case where the second polyolefin resin is a butene polymer. The weight average molecular weight is obtained by GPC measurement of the second polyolefin resin. In a case where the lower limit of the weight average molecular weight of the second polyolefin resin is less than the above range, there arises a problem of outgas generation due to a low molecular weight. In a case where the upper limit of the weight average molecular weight of the second polyolefin resin is more than the above range, there arises a problem of difficulty in application of the sealing material to a base material due to an increased melt viscosity of the sealing material or an increased solution viscosity of the sealing material (in a case where the sealing material is prepared in the form of liquid).

On the other hand, in a case where the second polyolefin resin contained in the sealing material of the present invention is not a butene polymer, the weight average molecular weight obtained by the GPC measurement is not particularly limited as long as the excellent gas barrier property-obtaining effect is brought about by an embodiment of the present invention further containing the second polyolefin resin.

The GPC measurement of the second polyolefin resin can be carried out by, for example, the method described in Examples later.

In a case where the sealing material of the present invention contains the second polyolefin resin and the modified polyolefin resin, an arrangement (combination) of the second polyolefin resin and the modified polyolefin resin is not particularly limited. For example, it is possible to appropriately combine any of the above examples of the second polyolefin resin and any of the above examples of the modified polyolefin resin.

In a case where the sealing material of the present invention contains the second polyolefin resin and the modified polyolefin resin, the content of the second polyolefin resin in the sealing material can be, for example, 0.01% by weight to 100% by weight, preferably 0.1% by weight to 80% by weight, and more preferably 1% by weight to 70% by weight when an involatile component content in the sealing material is 100% by weight. If the content of the second polyolefin resin in the sealing material is in the above range, it is advantageously possible not only to maintain an excellent adhesion strength but also to achieve an excellent water vapor barrier property.

In a case where the sealing material of the present invention contains the second polyolefin resin and the modified polyolefin resin, the content of the modified polyolefin resin in the sealing material can be, for example, 0.1% by weight to 50% by weight, preferably 1% by weight to 40% by weight, and more preferably 5% by weight to 30% by weight when an involatile component content in the sealing material is 100% by weight. If the content of the modified polyolefin resin in the sealing material is in the above range, it is advantageously possible not only to maintain an excellent adhesion strength but also to achieve an excellent gas barrier property, as advantageous effects.

The form of the sealing material of the present invention is not particularly limited as long as it is possible to achieve intended sealing. The sealing material can be, for example, in the form of liquid or solid. In a case where the sealing material is in the form of solid, the sealing material can have, for example, a sheet shape or a film shape. In a case where the sealing material of the present invention has a sheet shape or a film shape, a release film or a release paper may be attached to a surface of the sealing material so that until the sealing material is brought into contact with a barrier film, storage stability is ensured.

The sealing material of the present invention can contain any of various additives in addition to the above-described components, provided that the effect of an embodiment of the invention is not hindered. Examples of such an additive encompass an antioxidant, a gas adsorption material, a viscosity modifier, an antioxidant, a heat stabilizer, a light stabilizer, an ultraviolet absorber, a filler, a surfactant, a coupling agent, a colorant, an antistatic agent, a flame retardant, wax, and a plasticizer.

Since the sealing material of the present invention is configured as above, the sealing material is excellent in optical characteristics, flexibility and water vapor barrier property, and also can achieve a high adhesion strength with respect to a barrier film even in a case where any tackifier is not used. These are excellent effects of the sealing material of the present invention.

The optical characteristics of the sealing material of the present invention can be measured and evaluated on the basis of, for example, a total luminous transmittance and/or a haze. Refer to Examples (described later) for specific methods of measurement and evaluation of the total luminous transmittance and the haze.

The total luminous transmittance of the sealing material of the present invention is, for example, not less than 90%, preferably not less than 91%, and more preferably not less than 92%. The haze of the sealing material of the present invention is, for example, not more than 15%, preferably not more than 10%, and more preferably not more than 5%. In a case where the total luminous transmittance and/or the haze of the sealing material of the present invention is/are in the above range(s), the sealing material causes less loss in taking light into/out of an organic electronic device. This is an advantage of the sealing material.

The water vapor barrier property of the sealing material of the present invention can be measured and evaluated on the basis of, for example, a water vapor transmission rate. Refer to Examples (described later) for a specific method of measurement and evaluation of the water vapor transmission rate.

The water vapor transmission rate of the sealing material of the present invention is, for example, not more than 15 g/m$^2$·24 h, preferably not more than 12 g/m$^2$·24 h, and more preferably not more than 10 g/m$^2$·24 h. In a case where the water vapor transmission rate of the sealing material of the present invention is in the above range, the sealing material can suppress deterioration of the organic electronic device due to water vapor. This is an advantage of the sealing material.

The adhesion strength of the sealing material of the present invention with respect to a barrier film can be measured and evaluated on the basis of, for example, a peel strength with respect to PET and a peel strength with respect to glass. Refer to Examples (described later) for specific methods of measurement and evaluation of the peel strength with respect to PET and the peel strength with respect to glass.

The peel strength of the sealing material of the present invention with respect to PET can be, for example, not less than 7 N/25 mm, preferably not less than 10 N/25 mm, and more preferably not less than 15 N/25 mm. Meanwhile, the peel strength of the sealing material of the present invention with respect to glass can be, for example, not less than 6 N/25 mm, preferably not less than 10 N/25 mm, and more preferably not less than 15 N/25 mm. In a case where the sealing material of the present invention has the peel strength with respect to PET and/or the peel strength with respect to glass in the above range(s), it is possible to prevent peeling of a barrier film and suppress deterioration of the organic electronic device due to the peeling of the barrier film. This is an advantage of the sealing material.

As described above, the sealing material of the present invention can achieve a high adhesion strength with respect to a barrier film particularly without use of a tackifier. Note that in an embodiment of the present invention, it is preferable that the sealing material of the present invention contain no or substantially no tackifier from the viewpoint of reducing outgas generation. Note however that the sealing material may contain a tackifier in an amount that does not hinder the effect of an embodiment of the present invention. Specifically, the amount of the tackifier which may be contained in the sealing material of the present invention is preferably not more than 30% by weight and more preferably not more than 10% by weight.

The flexibility of the sealing material of the present invention can be measured and evaluated on the basis of, for example, a storage modulus at 10°C to 50°C. The storage modulus is measured by the rotational rheometer mentioned above. Refer to the description above and Examples (described later) for details.

In production of the sealing material of the present invention, it is possible to use any well-known device in the technical field to which the present invention pertains. In a mixing step in production of the sealing material of the present invention, it is possible to use a solvent or no solvent. In the case of a mixing device for producing the sealing material of the present invention with use of a solvent, the mixing device is not particularly limited as long as being capable of stirring and mixing raw materials with a solvent. The mixing device using a solvent can be, for example, a mechanical stirrer, or a shaking stirrer. In a case where a mixing device for producing the sealing material of the present invention without use of any solvent, the mixing device is not particularly limited as long as being capable of melt mixing raw materials. Examples of the mixing device using no solvent encompass a stirring kneader, a roll, a Banbury mixer, a kneader, and an extruder, each of which includes a heating device.

In one example, the sealing material of the present invention is produced by (i) first heating and melting and (ii) subsequently uniformly mixing a mixture of the modified polyolefin resin and the second polyolefin resin as in Examples described later. The heating and melting can be carried out before or after the modified polyolefin resin and the second polyolefin resin are mixed with each other.

[2. Barrier film]

An embodiment of the present invention provides a barrier film including, at a surface thereof, the sealing material of the present invention described above. The barrier film in accordance with an embodiment of the present invention will be hereinafter referred to as "barrier film of the present invention" as appropriate.

In a case where the flexible organic device is prepared by sealing an organic element between barrier films, a flexible organic device 5 is prepared as follows, as simply illustrated in Fig. 1: (i) provide a sealing material (sealing sheet) 2 on a barrier film 1, (ii) sandwich an organic element (element) 3 between two barrier films 1 on each of which the sealing material (sealing sheets) 2 is provided, and (iii) carry out thermal lamination 4. The barrier film of the present invention is intended to mean a barrier film having a surface on which a sealing material (sealing sheet) is provided. The barrier film of the present invention is not particularly limited, provided that the barrier film of the present invention includes, at its surface, the sealing material of the present invention. The barrier film of the present invention can be a film produced by providing the sealing material (sealing sheet) 2 on the barrier film 1 as illustrated in Fig. 1, or alternatively, a film produced by applying the sealing material of the present invention (in the form of liquid) to a surface of a barrier film. The barrier film of the present invention can have a surface entirely covered by the sealing material of the present invention. However, provided that the organic element can be sufficiently sealed, it is not necessary to have the surface of the barrier film entirely covered by the sealing material of the present invention, and the surface of the barrier film can be partially covered by the sealing material of the present invention.

The barrier film of the present invention employs the sealing material which has excellent effects with regard to optical characteristics, flexibility, a water vapor barrier property, and adhesion strength with respect to the barrier film. This allows the barrier film of the present invention to similarly achieve the excellent effects.

The barrier film of the present invention is not particularly limited in, for example, its material, provided that the barrier film is a film that can be used for a flexible organic device. The barrier film of the present invention may employ a well-known material.

The film used for the barrier film of the present invention can be, for example, a film made of an organic material or an organic material having a surface coated with an inorganic material, a film made of a flexible inorganic material, or a film made of a laminate in which any one or more of the foregoing organic/inorganic materials is/are provided in a layer(s). Examples of the organic material of the film encompass polyethylene terephthalate (PET), polyethylene naphthalate (PEN), and polyvinylidene fluoride. Further, examples of the inorganic material coating the surface of the organic material encompass silicon oxide, nitrogen oxide, and metal. Meanwhile, the flexible inorganic material can be, for example, a glass sheet film.

The sealing material of the present invention has an adhesive characteristic with which the sealing material firmly adheres to both of the organic material and the inorganic material. Therefore, the barrier film of the present invention can be produced by using, for example, any of the above-described various materials.

The barrier film of the present invention can be produced by any well-known method in the technical field to which the present invention pertains. The barrier film of the present invention is produced by a method such as T-die coating, spray coating, roll coater, or flow coater, but the method is not limited to these.

[3. Flexible organic device]

An embodiment of the present invention provides a flexible organic device including the barrier film of the present invention. The flexible organic device in accordance with an embodiment of the present invention is hereinafter referred to as "flexible organic device of the present invention" as appropriate. The flexible organic device of the present invention is a flexible organic device which is prepared by sealing an organic element or the like between the barrier films of the present invention as described in the preceding section of the present specification. In other words, how the flexible organic device is configured is not particularly limited, provided that the flexible organic device is prepared by using the barrier films of the present invention which includes the sealing material of the present invention. Examples of the flexible organic device of the present invention encompass an organic thin film solar cell, an organic electroluminescence (EL) display, an organic EL illumination, an organic transistor, an organic memory, and a flexible capacitor device.

Since the flexible organic device of the present invention employs the sealing material which has excellent effects with regard to optical characteristics, flexibility, a water vapor barrier property, and adhesion strength with respect to the barrier films, the barrier films of the present invention can similarly achieve the excellent effects.

An embodiment of the present invention encompasses the following configurations.

[1] A sealing material for a flexible organic device, the sealing material including:

a modified polyolefin resin,
the modified polyolefin resin being a polyolefin resin modified by at least one selected from the group consisting of an acid anhydride and a substitution product thereof, acrylic acid ester, methacrylic acid ester, vinyl ester, and a styrene derivative,
the sealing material satisfying the following (1) and (2):

(1) a degree of crystallinity in evaluation of degree of crystallinity (XRD) is in a range of 10% to 40%; and
(2) a storage modulus at 10°C to 50°C is in a range of 1 MPa to 100 MPa, the storage modulus being measured by a rotational rheometer.

[2] The sealing material as described in [1], further including a second polyolefin resin which is different from the modified polyolefin resin.
[3] The sealing material as described in [1] or [2], wherein the modified polyolefin resin has a weight average molecular weight of 1000 to 400000, the weight average molecular weight being obtained by GPC measurement of the modified polyolefin resin.
[4] The sealing material as described in any one of [1] to [3], wherein the modified polyolefin resin is a polyolefin resin modified by maleic anhydride.
[5] The sealing material as described in any one of [2] to [4], wherein the second polyolefin resin is a butene polymer.
[6] The sealing material as described in [5], wherein the second polyolefin resin has a weight average molecular weight of 2000 to 100000, the weight average molecular weight being obtained by GPC measurement of the second polyolefin resin.
[7] A barrier film including, at a surface thereof, a sealing material as described in any one of [1] to [6].
[8] A flexible organic device including a barrier film as described in [7].

Besides, it should be noted that the configuration described in each of the above items [1] to [8] can also be applied to another item(s) as appropriate. Further, the present invention is not limited to the embodiments, but can be altered by a skilled person in the art within the scope of the claims. The present invention also encompasses, in its technical scope, any embodiment derived by combining technical means disclosed in differing embodiments.

Examples

The following will provide a more detailed description of one or more embodiments of the present invention, based on Examples. However, the one or more embodiments of the present invention are not limited to the following Examples.

[Evaluation methods]

(1. Degree of crystallinity)

The degree of crystallinity of a resin composition was calculated from a profile which had been obtained by measurement of wide-angle X-ray diffraction. Specifically, first, calculation was carried out to obtain an integral intensity at a diffraction peak of each of an amorphous portion and a crystalline portion of a resin. Then, the degree of crystallinity was calculated by the following formula.

$$\text{Degree of crystallinity (\%)} = (\text{integral intensity of crystalline portion}/\text{integral intensity of amorphous portion and integral intensity of crystalline portion}) \times 100$$

Note that the degree of crystallinity was measured by an X-ray diffractometer (manufactured by Bruker AXS K.K., D2 PHASER).

(2. Storage moduli at 10°C and 50°C)

The storage modulus G' was measured as follows. Specifically, a resin composition was first melted and formed into a columnar shape having a diameter of 8 mm and a film thickness of 1000 $\mu$m to 2000 $\mu$m. Then, the resin composition was measured by a dynamic viscoelasticity measuring device (rotational rheometer, DHR-2, manufactured by TA instruments) with use of a parallel plate geometry of 8 mm in diameter. This measurement was carried out at a measurement frequency of 1 Hz, a strain of 0.05%, a temperature increase rate of 5°C/min, and a measurement temperature range of 0°C to 100°C.

(3. Peel strength with respect to PET)

The resin composition obtained in each of Examples and Comparative Examples was applied to a polyethylene terephthalate (PET) film having a thickness of 50 um, by using a slot die coater (mirror coater, manufactured by SUNTOOL CORPORATION). The resin composition thus applied had a thickness of 60 um. The film thus obtained was superimposed on a PET film on which no resin composition had been applied, and then subjected to thermocompression bonding at 140°C for 5 seconds, so that a test piece was obtained. Meanwhile, in Comparative Example 3 (containing a cyclic olefin resin) described later, a film of 60 um in thickness was prepared by hot stamping and sandwiched between PET films. Then, the film thus prepared was similarly subjected to thermocompression bonding, so that a test piece was obtained. After test pieces thus obtained were left at room temperature for 24 hours, the strength of peeling at a rate of 10 mm/min was measured. This test was carried out for three test pieces. Then, an average of measurement values obtained by using the three test pieces was calculated. The average thus obtained was regarded as a peel strength with respect to PET.

(4. Peel strength with respect to glass)

Test pieces were obtained, like the test pieces for measurement of the peel strength with respect to PET. Specifically, first, resin compositions were each applied to the PET film so that the resin composition would have a thickness of 60 um. Then, a film thus obtained was superimposed on a glass plate having a thickness of 0.7 mm. Subsequently, thermocompression bonding was carried out at 140°C for 5 seconds to give a test piece. Meanwhile, in Comparative Example 3 (containing a cyclic olefin resin) described later, a film of 60 um in thickness was prepared by hot stamping and sandwiched between the PET film and the glass plate. Then, the film thus prepared was similarly subjected to thermocompression bonding, so that a test piece was obtained. After test pieces thus obtained were left at room temperature for 24 hours, the strength of peeling at a rate of 10 mm/min was measured. This test was carried out for three test pieces. Then, an average of measurement values obtained by using the three test pieces was calculated. The average thus obtained was regarded as a peel strength with respect to glass.

(5. Total luminous transmittance)

Films having a thickness of 60 um were each formed from a resin which had been heated to a temperature higher than a softening point and melted. The total luminous transmittance was evaluated according to JIS K7361 and ISO13468-1, by using the films thus obtained. Note that the total luminous transmittance was measured by using a turbidity meter (NDH5000, manufactured by Denshoku Industries Co., Ltd.).

(6. Haze)

The haze was evaluated according to JIS K7136 and ISO14782, by using resin films which were the same as those used in evaluation of the total luminous transmittance. Note that the haze was measured by using the turbidity meter (NDH5000, manufactured by Denshoku Industries Co., Ltd.).

(7. Water vapor transmission rate)

Films having a thickness of 100 um were prepared by the same method as the films prepared for measurement of the total luminous transmittance. The water vapor transmission rate was evaluated by the Dish Method according to JIS Z0208, with use of the films.

(8. GPC measurement)

A number average molecular weight and a weight average molecular weight of polyolefin were calculated on the basis of an elution time in gel permeation chromatography (GPC) measurement under the following conditions.

- Apparatus: Viscotek HT-GPC (manufactured by Malvern)
- Column: GMHHR-H(20) HT2
- Mobile phase: o-dichlorobenzene
- Detector: differential refractometer (RI)
- Dissolved sample concentration: 1 wt%
- Column temperature: 140°C

[Materials]

(Polyolefin)

- LICOCENE (registered trademark) PP1602: manufactured by Clariant Japan K.K., ethylene-propylene copolymer, ethylene:propylene = 15 mol%:85 mol%
- VISTAMAXX (registered trademark) 6102: manufactured by ExxonMobil Japan, ethylene-propylene copolymer, ethylene:propylene = 16 mol%:84 mol%
- VERSIFY (registered trademark) 3401: manufactured by Dow Chemical Company, ethylene-propylene copolymer, ethylene:propylene = 15 mol%:85 mol%
- PORIBISU (registered trademark) 200N: manufactured by NOF CORPORATION, polybutene, number average molecular weight: 2650
- Tetrax (registered trademark) Grade6T: manufactured by JXTG Nippon Oil & Energy Corporation, polyisobutylene, viscosity average molecular weight: 60000
- Tetrax (registered trademark) Grade3T: manufactured by JXTG Nippon Oil & Energy Corporation, polyisobutylene, viscosity average molecular weight: 30000

(Acid-modified polyolefin)

- UMEX (registered trademark) 1010: manufactured by Sanyo Chemical Industries, Ltd., maleic anhydride-modified polypropylene, weight average molecular weight: 30000
- LICOCENE PPMA6252: manufactured by Clariant Japan K.K., maleic anhydride-modified polypropylene, weight average molecular weight: 8500
- acid-modified polyolefin 1: produced by a method described later in [Production Example 1], weight average molecular weight: 75000

(Ethylene-vinyl acetate copolymer (EVA))

- Ultrathene (registered trademark) 685: manufactured by Tosoh Corporation, ethylene-vinyl acetate copolymer, vinyl acetate content: 14 wt%

(Cyclic polyolefin)

- ZNR-1060R: manufactured by Zeon Corporation, cyclic polyolefin, glass transition temperature: 100°C

(Others)

- TAFMER (registered trademark) BL4000: manufactured by Mitsui Chemicals, Inc., polybutene, number average molecular weight: 140000
- SYLVARES (registered trademark) SA100: Kraton Polymer Japan Co., Ltd., $\alpha$-methylstyrene copolymer, number average molecular weight: 870

[Production Example 1]

First, 750 g of polyolefin (LICOCENE PP1602 manufactured by Clariant Japan K.K., softening point: 88°C) was put in a stainless-steel (SUS) reaction kettle, and melted at 170°C. Thereafter, inside the SUS reaction kettle, a nitrogen atmosphere was formed. Then, 22.5 g of maleic anhydride, 5 g of dicumyl peroxide, and 22.5 g of butyl methacrylate were dropped over an hour on the polyolefin which had been melted in the reaction kettle. After this dropping, stirring was carried out at 170°C for 30 minutes. Subsequently, the reaction kettle was depressurized, so that removal of an unreacted substance(s) and a low molecular weight compound(s) resulting from degradation of dicumyl peroxide was carried out for an hour. A resultant product thus obtained was a simple yellow solid. As a result of examining this solid, this solid was found to be a polyolefin which had been modified by maleic anhydride and butyl methacrylate (acid-modified polyolefin 1). The acid-modified polyolefin 1 had a viscosity of 7000 mPa·s at 170°C.

[Example 1]

First, LICOCENE PP1602 (polyolefin) and UMEX 1010 (acid-modified polyolefin) were mixed at a proportion (parts by weight) shown in Table 1. Then, a resultant mixture was heated and melted, and further uniformly mixed so as to give a resin composition.

[Table 1]

| | | Examples | | | | | | | | Comparative Exmaples | | | |
|---|---|---|---|---|---|---|---|---|---|---|---|---|---|
| | | 1 | 2 | 3 | 4 | 5 | 6 | 7 | 8 | 1 | 2 | 3 | 4 |
| Polyolefin | LICOCENE PP1602 | 100 | | | 100 | | | | | 100 | | | |
| | VISTAMAXX 6102 | | 100 | | | | | | | | | | |
| | VERSIFY 3401 | | | 100 | | | | | | | | | |
| | PORIBISU 200N | | | | | | 20 | | | | | | |
| | Tetrax Grade6T | | | | | | | 20 | | | | | |
| | Tetrax Grade3T | | | | | | | | 20 | | | | |

(continued)

| | | Examples | | | | | | | | Comparative Exmaples | | | |
|---|---|---|---|---|---|---|---|---|---|---|---|---|---|
| | | 1 | 2 | 3 | 4 | 5 | 6 | 7 | 8 | 1 | 2 | 3 | 4 |
| Acid-modified polyolefin | UMEX 1010 | 3 | 3 | 3 | | | | | | | | 50 | |
| | LICOCENE PPMA6252 | | | | 3 | | | | | | | | |
| | Acid-modified polyolefin 1 | | | | | 100 | 80 | 80 | 80 | | | | |
| EVA | Ultrathene 685 | | | | | | | | | | 100 | | |
| Cyclic polyolefin | ZNR-1060R | | | | | | | | | | | 50 | |
| Polyolefin tackifier | TAFMER BL4000 | | | | | | | | | | | | 50 |
| | SYLVARES SA100 | | | | | | | | | | | | 50 |

[Example 2]

A resin composition was produced as in Example 1, except that VISTAMAXX 6102 was used in place of LICOCENE PP1602.

[Example 3]

A resin composition was produced as in Example 1, except that VERSIFY 3401 was used in place of LICOCENE PP1602.

[Example 4]

A resin composition was produced as in Example 1, except that LICOCENE PPMA6252 was used in place of UMEX 1010.

[Example 5]

A resin composition was produced as in Example 1, except that (i) the acid-modified polyolefin 1 prepared in the above [Production Example 1] was used, at a proportion shown in Table 1, in place of UMEX 1010 and (ii) LICOCENE PP1602 was not used.

[Example 6]

A resin composition was produced as in Example 1 except that (i) PORIBISU 200N was used, at a proportion shown in Table 1, in place of LICOCENE PP1602 and (ii) the acid-modified polyolefin 1 prepared in the above [Production Example 1] was used, at a proportion shown in Table 1, in place of UMEX 1010.

[Example 7]

A resin composition was produced as in Example 1, except that (i) Tetrax Grade6T was used, at a proportion shown in Table 1, in place of LICOCENE PP1602 and (ii) the acid-modified polyolefin 1 prepared in the above [Production Example 1] was used, at a proportion shown in Table 1, in place of UMEX 1010.

[Example 8]

A resin composition was produced as in Example 1, except that (i) Tetrax Grade3T was used, at a proportion shown in Table 1, in place of LICOCENE PP1602 and (ii) the acid-modified polyolefin 1 prepared in the above [Production Example 1] was used, at a proportion shown in Table 1, in place of UMEX 1010.

[Comparative Example 1]

A resin composition was produced as in Example 1, except that UMEX 1010 was not used.

[Comparative Example 2]

A resin composition was produced as in Example 1, except that Ultrathene 685 was used, at a proportion shown in Table 1, in place of LICOCENE PP1602 and UMEX 1010.

[Comparative Example 3]

A resin composition was produced as in Example 1, except that ZNR-1060R was used in place of LICOCENE PP1602 and mixed at a proportion shown in Table 1 with UMEX 1010.

[Comparative Example 4]

A resin composition was produced as in Example 1, except that TAFMER BL4000 and SYLVARES SA100 were used, at respective proportions shown in Table 1, in place of LICOCENE PP1602 and UMEX 1010.

(Results)

With regard to the resin compositions obtained in Examples 1 to 8 and Comparative Examples 1 to 4, respectively, various parameters were measured by methods described above in the section of [Evaluation methods]. Table 2 shows results of this evaluation.

[Table 2]

| | Degree of crystallinity [%] | Storage modulus (G') [MPa] | | Peel strength [N/25 mm] | | Total luminous transmittance [%] | Haze [%] | Water vapor transmission rate [g/m2·24h] |
|---|---|---|---|---|---|---|---|---|
| | | 10°C | 50°C | w.r.t. PET | w.r.t. glass | | | |
| Example 1 | 21 | 7.7 | 2.1 | 18 | 11 | 92 | 4 | 12 |
| Example 2 | 12 | 3.4 | 1.5 | 16 | 10 | 91 | 5 | 11 |
| Example 3 | 11 | 15 | 7.1 | 15 | 10 | 91 | 5 | 11 |
| Example 4 | 25 | 7.8 | 2.1 | 15 | 1 | 91 | 4 | 12 |
| Example 5 | 18 | 7.5 | 3 | 27 | 15 | 92 | 3 | 11 |
| Example 6 | 13 | 1.2 | 4.2 | 18 | 24 | 92 | 2 | 9 |
| Example 7 | 14 | 3.5 | 1.4 | 20 | 24 | 92 | 15 | 9 |
| Example 8 | 14 | 2.9 | 1.1 | 20 | 25 | 92 | 6 | 8 |
| Comparative Example 1 | 22 | 6.9 | 1.8 | < 1 | < 1 | 92 | 2 | 11 |
| Comparative Example 2 | 14 | 11 | 2.2 | 6 | 5 | 93 | < 1 | 180 |
| Comparative Example 3 | 48 | 250 | 167 | < 1 | < 1 | 89 | 42 | 9 |
| Comparative Example 4 | 32 | 98 | 74 | < 1 | < 1 | 87 | 70 | 13 |

As compared to the resin compositions in accordance with Comparative Examples, in a case where the resin compositions in accordance with Examples of the present invention were used, excellent effects were found with regard to the peel strength with respect to PET, the peel strength with respect to glass, the total luminous transmittance, the haze, and the water vapor transmission rate. In other words, in an aspect of the present invention, the resin composition has some or all of the above characteristics.

It was also found that in a case where the acid-modified polyolefin was used alone (Example 5), excellent effects were similarly brought about as in cases in each of which the acid-modified polyolefin and the polyolefin were contained (Examples 1 to 4, and 6 to 8).

Note that in a case where the resin compositions in accordance with embodiments of the present invention were used (Examples 1 to 8), the problem of outgas generation did not occur.

Industrial Applicability

As describe above, a sealing material in accordance with an embodiment of the present invention has a high total luminous transmittance, a low haze, flexibility, a high water vapor barrier property, and a high adhesion strength with respect to barrier films. Therefore, an embodiment of the present invention can be more broadly applied in the field of flexible organic devices such as organic thin film solar cells.

Reference Signs List

1    barrier film
2    sealing material (sealing sheet)
3    organic element (element)
4    thermal lamination
5    flexible organic device

**Claims**

1.   A sealing material for a flexible organic device, the sealing material comprising:

a modified polyolefin resin,
the modified polyolefin resin being a polyolefin resin modified by at least one selected from the group consisting of an acid anhydride and a substitution product thereof, acrylic acid ester, methacrylic acid ester, vinyl ester, and a styrene derivative,
the sealing material satisfying the following (1) and (2):

(1) a degree of crystallinity in evaluation of degree of crystallinity (XRD) is in a range of 10% to 40%; and
(2) a storage modulus at 10°C to 50°C is in a range of 1 MPa to 100 MPa, the storage modulus being measured by a rotational rheometer.

2.   A sealing material as set forth in claim 1, further comprising a second polyolefin resin which is different from the modified polyolefin resin.

3.   The sealing material as set forth in claim 1 or 2, wherein the modified polyolefin resin has a weight average molecular weight of 1000 to 400000, the weight average molecular weight being obtained by GPC measurement of the modified polyolefin resin.

4.   The sealing material as set forth in any one of claims 1 to 3, wherein the modified polyolefin resin is a polyolefin resin modified by maleic anhydride.

5.   The sealing material as set forth in any one of claims 2 to 4, wherein the second polyolefin resin is a butene polymer.

6.   The sealing material as set forth in claim 5, wherein the second polyolefin resin has a weight average molecular weight of 2000 to 100000, the weight average molecular weight being obtained by GPC measurement of the second polyolefin resin.

7.   A barrier film comprising, at a surface thereof, a sealing material as recited in any one of claims 1 to 6.

8.   A flexible organic device comprising a barrier film as recited in claim 7.

FIG. 1

EP 3 702 430 A1

## INTERNATIONAL SEARCH REPORT

| | International application No. |
|---|---|
| | PCT/JP2018/028883 |

**A. CLASSIFICATION OF SUBJECT MATTER**
Int.Cl. C09K3/10(2006.01)i, B32B27/32(2006.01)i, C08L23/00(2006.01)i, C08L23/26(2006.01)i, H01L51/44(2006.01)i, H01L51/50(2006.01)i, H05B33/04(2006.01)i, H05B33/10(2006.01)i
According to International Patent Classification (IPC) or to both national classification and IPC

**B. FIELDS SEARCHED**

Minimum documentation searched (classification system followed by classification symbols)
Int.Cl. C09K3/10-12, B32B1/00-43/00, C08L23/26, H01L51/44, H05B33/00-28, G02F1/15-19

Documentation searched other than minimum documentation to the extent that such documents are included in the fields searched
Published examined utility model applications of Japan       1922–1996
Published unexamined utility model applications of Japan     1971–2018
Registered utility model specifications of Japan              1996–2018
Published registered utility model applications of Japan     1994–2018

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2012-216805 A (SEKISUI CHEMICAL CO., LTD.) 08 November 2012, claims, paragraphs [0004], [0031], examples (Family: none) | 1-8 |
| X | WO 2015/068805 A1 (NIPPON KAYAKU KK) 14 May 2015, claims, paragraphs [0015], [0026], examples & CN 105637029 A & KR 10-2016-0086317 A | 1-8 |
| X | JP 2015-137333 A (MITSUI CHEMICALS, INC.) 30 July 2015, claims, paragraph [0094], examples (Family: none) | 1-8 |

☐ Further documents are listed in the continuation of Box C.      ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27.09.2018 | 09.10.2018 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**EP 3 702 430 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012073675 A
- JP 2014146582 A
- JP 2017027941 A